# EUROPÄISCHE PATENTSCHRIFT

(11) **EP 1 642 347 B1**
(45) Veröffentlichungstag und Bekanntmachung des Hinweises auf die Patenterteilung: **13.08.2008**
(21) Anmeldenummer: 04738791.5
(22) Anmeldetag: 25.06.2004
(51) Int. Cl.: H01L 33/00

(54) **STRAHLUNGSEMITTIERENDES HALBLEITERBAUELEMENT**
RADIATION-EMITTING SEMI-CONDUCTOR COMPONENT
COMPOSANT A SEMICONDUCTEUR EMETTEUR DE RAYONNEMENT

(30) Priorität: 27.06.2003 DE 10329079
(43) Veröffentlichungstag der Anmeldung: 05.04.2006
(60) Teilanmeldung: 08157597.9
(73) Patentinhaber: OSRAM Opto Semiconductors GmbH, 93055 Regensburg (DE)
(72) Erfinder: BUTENDEICH, Rainer, 93055 Regensburg (DE); LINDER, Norbert, 93173 Wenzenbach (DE); MAYER, Bernd, 93049 Regensburg (DE); PIETZONKA, Ines, 93049 Regensburg (DE)
(74) Vertreter: Epping - Hermann - Fischer
(86) Internationale Anmeldenummer: PCT/DE2004/001344
(87) Internationale Veröffentlichungsnummer: WO 2005/004244

(56) Entgegenhaltungen:
- EP-A- 0 762 516
- EP-A- 0 772 247
- EP-A- 1 079 444
- WO-A-00/24097
- DE-A1- 19 756 856
- US-A1- 2002 053 665

## Beschreibung

Die Erfindung betrifft ein strahlungsemittierendes Halbleiterbauelement mit einer Schichtstruktur, die eine n-dotierte Confinementschicht, eine p-dotierte Confinementschicht, und eine zwischen der n-dotierten Confinementschicht und der p-dotierten Confinementschicht angeordnete aktive, Photonen emittierende Schicht enthält.

Die Confinementschichten sind vorliegend Materialschichten oder Materialschichtabfolgen, die in der Lage sind, Ladungsträger auf eine Photonen erzeugende aktive Zone der Schichtstruktur zu beschränken.

Unter den Begriff "Confinementschicht" fällt im vorliegenden Zusammenhang sowohl eine einzelne Materialschicht als auch eine Materialschichtabfolge, die die Funktion einer Confinementschicht umfasst. Analog fällt unter den Begriff "Photonen emittierende Schicht" sowohl eine einzelne Materialschicht als auch eine Materialschichtabfolge, die in der Lage ist, im Betrieb Photonen zu emittieren.

Bei Laserdioden und Leuchtdioden auf der Basis von AlInGaP, aber auch bei anderen Materialsystemen, wird eine möglichst hohe n-Dotierung in den Confinementschichten angestrebt, um Ladungsträgerverluste durch Leckströme zu minimieren. Gleichzeitig ist ein scharfer Abfall der Dotierung am Rand des Wellenleiters einer Laserdiode wünschenswert, um eine erhöhte Absorption der Lasermode zu vermeiden. Werden diese Bedingungen erfüllt, so ist allerdings oft die elektrische, optische und/oder elektrooptische Qualität der (gegebenenfalls mit dem n-Dotierstoff dotierten) aktiven Schicht ungenügend. Werden dagegen andere Dotierstoffe verwendet, die zu einer Verbesserung der elektrischen bzw. optischen Qualität der aktiven Schicht führen, ergeben sich andere Nachteile, wie etwa eine geringere Effizienz der hergestellten Bauelemente.

Der vorliegenden Erfindung liegt die Aufgabe zugrunde, ein strahlungsemittierendes Halbleiterbauelement der eingangs genannten Art anzugeben, das eine verbesserte elektrische und/oder optische Qualität der aktiven Schicht und/oder eine hohe Effizienz aufweist.

Diese Aufgabe wird durch ein strahlungsemittierendes Halbleiterbauelement mit den Merkmalen des Patentanspruches 1 gelöst.

Weitere vorteilhafte Ausgestaltungen der Erfindung ergeben sich aus den Unteransprüchen 2 bis 13.

Bei einem strahlungsemittierenden Halbleiterbauelement gemäß der Erfindung, wie sie in Anspruch 1 definiert ist, ist vorgesehen, dass die n-dotierte Confinementschicht mit einem ersten n-Dotierstoff insbesondere zur Erzeugung einer hohen aktiven Dotierung und eines scharfen Dotierprofils dotiert ist, und die aktive Schicht mit einem von dem ersten Dotierstoff verschiedenen zweiten n-Dotierstoff insbesondere zur Verbesserung der Schichtqualität der aktiven Schicht dotiert ist.

Die Erfindung beruht somit auf dem Gedanken, zwei unterschiedliche n-Dotierstoffe einzusetzen, die an unterschiedlichen Stellen der Schichtstruktur eingebaut werden, so daß die unterschiedlichen Eigenschaften der beiden Dotierstoffe gezielt lokal ausgenutzt werden können.

Der erste n-Dotierstoff ist dabei so gewählt, daß er eine höchstmögliche aktive Dotierung der Confinementschicht und ein scharfes Dotierprofil erlaubt. Die aktive Schicht wird hingegen mit einem zweiten n-Dotierstoff dotiert, die geeignet ist, die elektrische und/oder optische Qualität der aktiven Schicht zu verbessern. Als Verbesserung kommt dabei insbesondere die Unterdrückung von Ordnungseffekten, wie sie beispielsweise aus K. L. Chang et al., J. Appl. Phys. 92, 6582 (2002) bekannt sind, oder die Unterdrückung von nichtstrahlenden Zentren in Betracht.

Die Offenlegungsschrift DE 197 56 856 A1 beschreibt eine Halbleiter-Lichtemissionsvorrichtung, in welcher eine Lichtemissionsschicht, die ein AIGaInP-Material als ein Grundmaterial enthält, auf einem GaP-Substrat in einem Zustand einer Gitterfehlanpassung mit dem GaP-Substrat aufgewachsen ist. Dabei zeichnet sich die Halbleiter-Lichtemissionsvorrichtung dadurch aus, dass das als das Grundmaterial der Lichtemissionsschicht verwendete AIGaInP-Material mit Stickstoff, Sauerstoff, Selen, Schwefel oder Tellur als einem ersten Fremdstoff zum Bilden eines Donatorniveaus und mit Magnesium, Zink oder Cadmium als einem zweiten Fremdstoff zum Bilden eines Akzeptorniveaus dotiert ist. Die zugehörigen Confinementschichten sind jeweils p- und n-dotiert.

Bei einer vorteilhaften Ausgestaltung der Erfindung ist vorgesehen, daß die n-dotierte Confinementschicht sowohl mit dem ersten n-Dotierstoff als auch mit einem weiteren Dotierstoff, insbesondere mit dem zweiten n-Dotierstoff dotiert ist. Dadurch kann eine Erhöhung der aktiven Dotierung bis zur Summe der beiden aktiven Dotierstoffkonzentrationen erzielt werden. Zugleich bleibt der Vorteil der hohen erreichbaren Dotierung und des scharfen Dotierprofils erhalten.

Bei einer bevorzugten Weiterbildung der Erfindung stellt das Halbleiterbauelement eine Leuchtdiode dar. Die aktive Schicht der Leuchtdiode kann dabei durch eine homogene Schicht oder durch einen Quantentopf oder einen Mehrfachquantentopf gebildet sein.

Bei einer anderen bevorzugten Weiterbildung der Erfindung stellt das Halbleiterbauelement eine kantenemittierende Laserdiode dar, bei der zwischen der aktiven Schicht und der n-dotierten Confinementschicht eine erste Wellenleiterschicht und zwischen der aktiven Schicht und der p-dotierten Confinementschicht eine zweite Wellenleiterschicht angeordnet ist.

Die erste Wellenleiterschicht der Laserdiode kann undotiert oder wie die aktive Schicht mit dem zweiten n-Dotierstoff dotiert sein. Sie kann aber auch mit beiden n-Dotierstoffen oder nur mit dem ersten n-Dotierstoff dotiert sein.

Die zweite Wellenleiterschicht ist vorzugsweise undotiert.

Als erster n-Dotierstoff wird bevorzugt Silizium eingesetzt, da sich mit Silizium sowohl sehr hohe n-Dotierungen als auch ein scharf abfallendes Dotierstoffprofil einstellen lassen.

Als zweiter n-Dotierstoff wird bevorzugt Tellur eingesetzt. Es wurde überraschend herausgefunden, daß Tellur die Eigenschaft hat, unerwünschte Ordnungseffekte in der aktiven Schicht zu unterdrücken bzw. allgemein die optischelektrische Qualität der aktiven Schicht zu verbessern. Auf der anderen Seite diffundiert Tellur während des epitaktischen Wachstums sehr stark, so daß der Einsatz von Tellur als einzigem Dotierstoff sowohl für die Confinementschicht als auch für die aktive Schicht zu Bauteilen mit vergleichsweise niedriger Effizienz führt.

Die p-dotierten Confinementschichten der Laserdioden oder Leuchtdioden sind bevorzugt mit Magnesium oder Zink dotiert.

Die Erfindung läßt sich mit besonderem Vorteil bei strahlungsemittierenden Halbleiterbauelementen einsetzen, deren Schichtstruktur auf Basis von AlInGaP gebildet ist.

Darüber hinaus kann die Erfindung auch bei Schichtstrukturen auf Basis von anderen Materialsystemen, wie etwa AlGaAs, InGaAlAs oder InGaAsP vorteilhaft verwendet werden, bei denen Ordnungseffekte auftreten können oder bei denen die elektrische und/oder optische Qualität der aktiven Schicht durch einen Dotierstoff beeinflußbar ist.

Unter die Gruppe von derartigen Schichtstrukturen auf der Basis von AlInGaP fällt in erster Linie jede für ein strahlungsemittierendes Halbleiterbauelement geeignete III/V-Verbindungshalbleiterstruktur der eingangs genannten Art, die eine Schichtenfolge aus unterschiedlichen Einzelschichten aufweist und die mindestens eine Einzelschicht enthält, die ein III/V-Verbindungshalbleiter-material aus dem Materialsystem AlₓIn_{y}Ga_{1-x-y}P mit 0 ≤ x ≤ 1, 0 ≤ y ≤ 1 und x+y ≤ 1, aufweist. Eine solche III/V-Verbindungshalbleiterstruktur kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert.

Analoges gilt für Schichtstrukturen auf Basis von AlGaAs, InGaAlAs oder InGaAsP.

Beim Einbringen der Dotierstoffe kann gegebenenfalls ein unterschiedliches Einbauverhalten der Dotierstoffe in Abhängigkeit von der Wachstumstemperatur ausgenutzt werden. Beispielsweise erhöht sich der Einbau von Silizium mit steigender Wachstumstemperatur, während sich der Tellureinbau verringert. So kann die Konzentration der verschiedenen Dotierstoffe in den Bauteilstrukturen über ein vorgegebenes Temperaturprofil eingestellt werden.

Weitere vorteilhafte Ausgestaltungen, Merkmale und Details der Erfindung ergeben sich aus der nachfolgenden Beschreibung der Ausführungsbeispiele in Verbindung mit den Zeichnungen.

Es zeigen:
- Figur 1: eine schematische Darstellung einer Schnittansicht einer Laserdiode nach einem Ausführungsbeispiel der Erfindung; und
- Figur 2: eine schematische Schnittansicht einer Leuchtdiode nach einem anderen Ausführungsbeispiel der Erfindung.

Es sei an dieser Stelle ausdrücklich darauf hingewiesen, dass die Schichtstrukturen und Schichtdickenrelationen in den Figuren nicht maßstabsgerecht dargestellt sind.

### Erstes Ausführungsbeispiel:

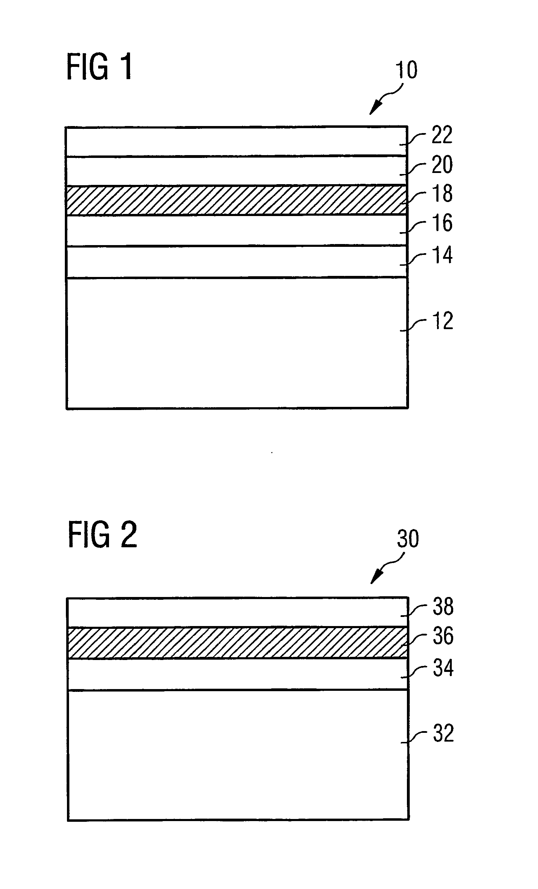

Das in Figur 1 in schematischer Schnittansicht dargestellte erste Ausführungsbeispiel der Erfindung ist eine kantenemittierende Laserdioden-Schichtstruktur 10 auf Basis von AlInGaP.

In der schematischen Darstellung der Figur 1 sind nur die für das Verständnis der Erfindung wesentlichen Schichten dargestellt. Es versteht sich jedoch, daß weitere Schichten, wie etwa Pufferschichten, Zwischenschichten, Kontaktschichten, Rampen und dergleichen ebenfalls vorhanden sein können.

Bei der Laserdioden-Schichtstruktur 10 ist auf ein Siliziumdotiertes GaAs-Substrat 12 eine Schichtenfolge auf Basis von AlInGaP aufgewachsen.

Diese Schichtenfolge auf Basis von AlInGaP umfaßt:
- eine n-dotierte In_{0.5}(AlₓGa₁₋ₓ)_{0.5}P-Confinementschicht 14, die vorzugsweise mit Silizium n-dotiert ist, auf dem GaAs-Substrat 12,
- eine aus Sicht des GaAs-Substrats 12 der n-dotierten Confinementschicht 14 nachgeordnete erste In_{0.5}(AlₓGa₁₋ₓ)_{0.5}P-Wellenleiterschicht 16, die undotiert ist,
- eine aus Sicht des GaAs-Substrats 12 der undotierten In_{0.5}(AlₓGa₁₋ₓ)_{0.5}P-Wellenleiterschicht 16 nachgeordnete Tellur-dotierte aktive In_{z}Ga_{1-z}P-Schicht 18,
- eine aus Sicht des GaAs-Substrats 12 der Tellur-dotierten aktiven In_{z}Ga_{1-z}P-Schicht 18 nachgeordnete zweite In_{0.5}(AlyGa_{1-y})_{0.5}P-Wellenleiterschicht 20, die undotiert ist, und
- eine aus Sicht des GaAs-Substrats 12 der zweiten In_{0.5}(Al_{y}Ga_{1-y})_{0.5}P-Wellenleiterschicht 20 nachgeordnete p-dotierte In_{0.5}(AlₓGa₁₋ₓ)_{0.5}P-Confinementschicht 22, die vorzugsweise mit Magnesium und/oder Zink p-dotiert ist.

Für die Index-Variablen x, y und z gilt hier: 0≤x≤1, 0≤y≤1 und 0≤z≤1.

Als erster n-Dotierstoff für die n-dotierte In_{0.5}(AlₓGa₁₋ₓ)_{0.5}P-Confinementschicht 14 wird bei diesem ersten Ausführungsbeispiel Silizium verwendet. Damit wird in der n-dotierten In_{0.5}(AlₓGa₁₋ₓ)_{0.5}P-Confinementschicht 14 eine vorteilhaft hohe n-Dotierung und zudem ein Dotierprofil mit einem scharfen Abfall erreicht.

Als zweiter Dotierstoff für die aktive In_{z}Ga_{1-z}P-Schicht 18 Schicht dient Tellur, das zur Ausbildung einer aktiven Schicht mit einer vorteilhaft hohen elektrischen und optischen Qualität dient. Insbesondere werden durch die Tellur-Dotierung unerwünschte Ordnungseffekte im Kristallgefüge der aktiven Schicht unterdrückt.

### Zweites Ausführungsbeispiel:

Bei einem zweiten Ausführungsbeispiel der Erfindung (vgl. ebenfalls Figur 1), wiederum eine kantenemittierende Laserdioden-Schichtstruktur auf Basis von AlInGaP, ist im Unterschied zum oben beschriebenen ersten Ausführungsbeispiel die erste In_{0.5}(AlₓGa₁₋ₓ)_{0.5}P-Wellenleiterschicht 16 ebenfalls mit Tellur dotiert. Damit ergibt sich eine Schichtenabfolge, bei der auf dem Silizium-dotierten GaAs-Substrat 12 eine mit Silizium n-dotierte In_{0.5}(AlₓGa₁₋ₓ)_{0.5}P-Confinementschicht 14, eine mit Tellur n-dotierte erste In_{0.5}(AlₓGa₁₋ₓ)_{0.5}P-Wellenleiterschicht 16, eine mit Tellur n-dotierte aktive In_{z}Ga_{1-z}P-Schicht 18, eine undotierte zweite In_{0.5}(Al_{y}Ga_{1-y})_{0.5}P-Wellenleiterschicht 20 und eine mit Magnesium oder Zink p-dotierte In_{0.5}(AlₓGa₁₋ₓ)_{0.5}P-Confinementschicht 22 aufgewachsen sind.

Optional kann die erste In_{0.5}(AlₓGa₁₋ₓ)_{0.5}P-Wellenleiterschicht 16 zusätzlich mit Silizium dotiert sein.

Durch die Dotierung der Wellenleiterschicht werden vorteilhafterweise die Ladungsträgerverluste weiter verringert bzw. die Effizienz des Bauelements erhöht.

### Drittes Ausführungsbeispiel:

Bei einem dritten Ausführungsbeispiel der Erfindung (vgl. ebenfalls Figur 1), wiederum eine kantenemittierende Laserdioden-Schichtstruktur auf Basis von AlInGaP, ist die n-dotierte In_{0.5}(AlₓGa₁₋ₓ)_{0.5}P-Confinementschicht 14 im Unterschied zum ersten Ausführungsbeispiel nicht nur mit einem, sondern mit beiden n-Dotierstoffen, das heißt sowohl mit dem ersten als auch mit dem zweiten eingesetzten n-Dotierstoff dotiert, um vorteilhafterweise die gesamte aktive Dotierstoffkonzentration im Idealfall bis auf die Summe der beiden Dotierstoffkonzentrationen zu erhöhen.

Die erste In_{0.5}(AlₓGa₁₋ₓ)_{0.5}P-Wellenleiterschicht 16 kann dabei undotiert, ebenfalls mit Tellur oder auch mit Silizium und Tellur dotiert sein.

Insgesamt ist damit bei diesem Beispiel auf dem Silizium-dotierten GaAs-Substrat 12 eine Schichtenfolge aufgewachsen, die folgende Schichten aufweist:
- eine mit Silizium und Tellur n-dotierte In_{0.5}(AlₓGa₁₋ₓ)_{0.5}P-Confinementschicht 14,
- eine undotierte oder mit Tellur n-dotierte erste In_{0.5}(AlₓGa₁₋ₓ)_{0.5}P-Wellenleiterschicht 16,
- eine mit Tellur n-dotierte aktive In_{z}Ga_{1-z}P-Schicht 18,
- eine undotierten zweite In_{0.5}(Al_{y}Ga_{1-y})_{0.5}P-Wellenleiterschicht 20 und
- eine mit Magnesium oder Zink p-dotierte In_{0.5}(AlₓGa₁₋ₓ)_{0.5}P-Confinementschicht 22.

Wie bei dem ersten Ausführungsbeispiel wird also als erster n-Dotierstoff Silizium und als zweiter n-Dotierstoff Tellur verwendet. Daraus resultieren wiederum die oben bereits geschilderten Vorteile.

### Viertes Ausführungsbeispiel:

Das in Figur 2 in schematischer Schnittansicht dargestellte vierte Ausführungsbeispiel der Erfindung ist eine Leuchtdioden-Schichtstruktur 30 auf Basis von AlInGaP, die auf einem Silizium-dotierten GaAs-Substrat 32 aufgewachsen ist.

Diese Schichtenfolge 30 auf Basis von AlInGaP umfaßt:
- eine n-dotierte In_{0.5}(AlₓGa₁₋ₓ)_{0.5}P-Confinementschicht 34, die vorzugsweise mit Silizium n-dotiert ist, auf dem GaAs-Substrat 12,
- eine aus Sicht des GaAs-Substrats 12 der n-dotierten In_{0.5}(AlₓGa₁₋ₓ)_{0.5}P-Confinementschicht 34 nachgeordnete n-dotierte aktive In_{0.5}(Al_{y}Ga_{1-y})_{0.5}P-Schicht 36, die vorzugsweise mit Tellur n-dotiert ist, und
- eine aus Sicht des GaAs-Substrats 12 der n-dotierten aktiven In_{0.5}(Al_{y}Ga_{1-y})_{0.5}P-Schicht 36, nachgeordnete p-dotierte In_{0.5}(AlₓGa₁₋ₓ)_{0.5}P-Confinementschicht 38, die vorzugsweise mit Magnesium und/oder Zink p-dotiert ist.

Die aktive Schicht kann dabei sowohl eine homogene Schicht darstellen, als auch durch einen Quantentopf- oder eine Mehrfachquantentopf-Struktur gebildet sein.

Wie bei den vorangehenden Ausführungsbeispielen wird also mit entsprechend vorteilhafter Wirkung bei der Leuchtdiode als erster n-Dotierstoff für die n-Confinementschicht 34 Silizium und als zweiter Dotierstoff für die aktive Schicht 36 Tellur verwendet.

Es versteht sich, daß die in der vorstehenden Beschreibung, in den Zeichnungen sowie in den Ansprüchen offenbarten Merkmale der Erfindung sowohl einzeln als auch in beliebiger Kombination für die Verwirklichung der Erfindung wesentlich sein können.

Die Erfindung ist selbstverständlich nicht durch die beispielhafte Beschreibung anhand der Ausführungsbeispiele auf diese beschränkt. Vielmehr umfasst die Erfindung jedes neue Merkmal sowie jede Kombination von Merkmalen, was insbesondere jede Kombination von einzelnen Merkmalen der verschiedenen Patentansprüche oder der verschiedenen Ausführungsbeispiele untereinander beinhaltet, auch wenn das betreffende Merkmal oder die betreffende Kombination selbst nicht explizit in den Patentansprüchen oder Ausführungsbeispielen angegeben ist.

## Patentansprüche

1. Strahlungsemittierendes Halbleiterbauelement mit einer Schichtstruktur, die
- eine n-dotierte Confinementschicht (14; 34),
- eine p-dotierte Confinementschicht (22; 38), und
- eine zwischen der n-dotierten Confinementschicht (14; 34) und der p-dotierten Confinementschicht (22; 38) angeordnete aktive, Photonen emittierende Schicht (18; 36) enthält, wobei- die n-dotierte Confinementschicht (14; 34) mit einem ersten n-Dotierstoff dotiert ist,
- die aktive Schicht (18; 36) mit einem von dem ersten Dotierstoff verschiedenen zweiten n-Dotierstoff dotiert ist, und
- die Schichtstruktur (14-22; 34-38) auf Basis von AlInGaP, AlGaAs, InGaAlAs oder InGaAsP gebildet ist, wobei
die n-dotierte Confinementschicht (14; 34) sowohl mit dem ersten n-Dotierstoff als auch mit einem weiteren n-Dotierstoff dotiert ist.

2. Strahlungsemittierendes Halbleiterbauelement nach Anspruch 1,
**dadurch gekennzeichnet, daß**
der weitere n-Dotierstoff der zweite n-Dotierstoff ist.

3. Strahlungsemittierendes Halbleiterbauelement nach einem der Ansprüche 1 oder 2,
**dadurch gekennzeichnet, daß**
das Halbleiterbauelement eine Leuchtdiode (30) darstellt.

4. Strahlungsemittierendes Halbleiterbauelement nach Anspruch 3,
**dadurch gekennzeichnet, daß**
die aktive Schicht (36) der Leuchtdiode durch eine homogene Schicht gebildet ist.

5. Strahlungsemittierendes Halbleiterbauelement nach Anspruch 3,
**dadurch gekennzeichnet, daß**
die aktive Schicht (36) der Leuchtdiode durch einen Quantentopf oder einen Mehrfachquantentopf gebildet ist.

6. Strahlungsemittierendes Halbleiterbauelement nach einem der Ansprüche 1 oder 2,
**dadurch gekennzeichnet, daß**
das Halbleiterbauelement eine Laserdiode (10) darstellt, bei der zwischen der aktiven Schicht (18) und der n-dotierten Confinementschicht (14) eine erste Wellenleiterschicht (16) und zwischen der aktiven Schicht (18) und der p-dotierten Confinementschicht (22) eine zweite Wellenleiterschicht (20) angeordnet ist.

7. Strahlungsemittierendes Halbleiterbauelement nach Anspruch 6,
**dadurch gekennzeichnet, daß**
die erste Wellenleiterschicht (16) undotiert ist.

8. Strahlungsemittierendes Halbleiterbauelement nach Anspruch 6,
**dadurch gekennzeichnet, daß**
die erste Wellenleiterschicht (16) mit dem zweiten n-Dotierstoff dotiert ist.

9. Strahlungsemittierendes Halbleiterbauelement nach einem der Ansprüche 6 bis 8,
**dadurch gekennzeichnet, daß**
die zweite Wellenleiterschicht (20) undotiert ist.

10. Strahlungsemittierendes Halbleiterbauelement nach einem der Ansprüche 1 bis 9,
**dadurch gekennzeichnet, daß**
als erster n-Dotierstoff Silizium eingesetzt wird.

11. Strahlungsemittierendes Halbleiterbauelement nach einem der Ansprüche 1 bis 10,
**dadurch gekennzeichnet, daß**
als zweiter n-Dotierstoff Tellur eingesetzt wird.

12. Strahlungsemittierendes Halbleiterbauelement nach einem der Ansprüche 1 bis 11,
**dadurch gekennzeichnet, daß**
die p-dotierte Confinementschicht (22; 38) mit Magnesium, Kohlenstoff oder Zink dotiert ist.

## Claims

1. Radiation-emitting semiconductor component with a layer structure comprising
- an n-doped confinement layer (14; 34),
- a p-doped confinement layer (22; 38), and
- an active, photon-emitting layer (18; 36) arranged between the n-doped confinement layer (14; 34) and the p-doped confinement layer (22; 38),
wherein
- the n-doped confinement layer (14; 34) is doped with a first n-type dopant,
- the active layer (18; 36) is doped with a second n-type dopant, which is different from the first dopant, and
- the layer structure (14-22; 34-38) is formed on the basis of AlInGaP, AlGaAs, InGaAlAs or InGaAsP, wherein the n-doped confinement layer (14; 34) is doped both with the first n-type dopant and with a further n-type dopant.

2. Radiation-emitting semiconductor component according to Claim 1,
**characterized in that**
the further n-type dopant is the second n-type dopant.

3. Radiation-emitting semiconductor component according to either of Claims 1 and 2,
**characterized in that**
the semiconductor component represents a light-emitting diode (30).

4. Radiation-emitting semiconductor component according to Claim 3,
**characterized in that**
the active layer (36) of the light-emitting diode is formed by a homogeneous layer.

5. Radiation-emitting semiconductor component according to Claim 3,
**characterized in that**
the active layer (36) of the light-emitting diode is formed by a quantum well or a multiple quantum well.

6. Radiation-emitting semiconductor component according to either of Claims 1 and 2,
**characterized in that**
the semiconductor component represents a laser diode (10) in which a first waveguide layer (16) is arranged between the active layer (18) and the n-doped confinement layer (14) and a second waveguide layer (20) is arranged between the active layer (18) and the p-doped confinement layer (22).

7. Radiation-emitting semiconductor component according to Claim 6,
**characterized in that**
the first waveguide layer (16) is undoped.

8. Radiation-emitting semiconductor component according to Claim 6,
**characterized in that**
the first waveguide layer (16) is doped with the second n-type dopant.

9. Radiation-emitting semiconductor component according to any of Claims 6 to 8,
**characterized in that**
the second waveguide layer (20) is undoped.

10. Radiation-emitting semiconductor component according to any of Claims 1 to 9,
**characterized in that**
silicon is used as the first n-type dopant.

11. Radiation-emitting semiconductor component according to any of Claims 1 to 10,
**characterized in that**
tellurium is used as the second n-type dopant.

12. Radiation-emitting semiconductor component according to any of Claims 1 to 11,
**characterized in that**
the p-doped confinement layer (22; 38) is doped with magnesium, carbon or zinc.

## Revendications

1. Composant semi-conducteur émetteur de rayonnement, qui présente une structure stratifiée qui contient :
- une couche de confinement (14; 34) dopée négativement,
- une couche de confinement (22; 38) dopée positivement et
- une couche active (18; 36) émettrice de photons, disposée entre la couche de confinement (14; 34) dopée négativement et la couche de confinement (22; 38) dopée positivement, la couche de confinement (14; 34) dopée négativement étant dopée par une première substance de dopage négatif,
- la couche active (18; 36) étant dopée par une deuxième substance négative différente de la première substance de dopage et
- la structure stratifiée (14-22; 34-38) étant formée à base d'AlInGaP, d'AlGaAs, d'InGaAlAs ou d'InGaAsP et
la couche de confinement (14; 34) dopée négativement étant dopée à la fois par la première substance de dopage négatif et par une autre substance de dopage négatif.

2. Composant semi-conducteur émetteur de rayonnement selon la revendication 1, **caractérisé en ce que** l'autre substance de dopage négatif est la deuxième substance de dopage négatif.

3. Composant semi-conducteur émetteur de rayonnement selon l'une des revendications 1 ou 2, **caractérisé en ce que** le composant semi-conducteur est une diode luminescente (30).

4. Composant semi-conducteur émetteur de rayonnement selon la revendication 3, **caractérisé en ce que** la couche active (36) de la diode luminescente est formée d'une couche homogène.

5. Composant semi-conducteur émetteur de rayonnement selon la revendication 3, **caractérisé en ce que** la couche active (36) de la diode luminescente est formée par une calotte quantique ou une calotte quantique multiple.

6. Composant semi-conducteur émetteur de rayonnement selon l'une des revendications 1 ou 2, **caractérisé en ce que** le composant semi-conducteur est une diode au laser (10) dans laquelle une première couche (16) de guide d'onde est formée entre la couche active (18) et la couche de confinement (14) dopée négativement et une deuxième couche (20) de guide d'onde est disposée entre la couche active (18) et la couche de confinement (22) dopée positivement.

7. Composant semi-conducteur émetteur de rayonnement selon la revendication 6, **caractérisé en ce que** la première couche (16) de guide d'onde n'est pas dopée.

8. Composant semi-conducteur émetteur de rayonnement selon la revendication 6, **caractérisé en ce que** la première couche (16) de guide d'onde est dopée par la deuxième substance de dopage négatif.

9. Composant semi-conducteur émetteur de rayonnement selon l'une des revendications 6 à 8, **caractérisé en ce que** la deuxième couche (20) de guide d'onde n'est pas dopée.

10. Composant semi-conducteur émetteur de rayonnement selon l'une des revendications 1 à 9, **caractérisé en ce que** comme première substance de dopage négatif, on utilise le silicium.

11. Composant semi-conducteur émetteur de rayonnement selon l'une des revendications 1 à 10, **caractérisé en ce que** comme deuxième substance de dopage négatif, on utilise le tellurium.

12. Composant semi-conducteur émetteur de rayonnement selon l'une des revendications 1 à 11, **caractérisé en ce que** la couche de confinement (22; 38) dopée positivement est dopée au magnésium, au carbone ou au zinc.
